(19) Europäisches Patentamt
European Patent Office
Office européen des brevets

(11) **EP 2 846 280 A1**

(12) **DEMANDE DE BREVET EUROPEEN**

(43) Date de publication:
**11.03.2015 Bulletin 2015/11**

(51) Int Cl.:
**G06F 17/50** (2006.01)

(21) Numéro de dépôt: **13306224.0**

(22) Date de dépôt: **06.09.2013**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(71) Demandeur: **Airbus Operations
31060 Toulouse (FR)**

(72) Inventeurs:
• **Messina, Paolo
31100 Toulouse (FR)**
• **Dubeaurepaire, Florian
31770 Colombiers (FR)**
• **Le Drogo, Stéphane
31100 Toulouse (FR)**

(74) Mandataire: **Santarelli
49, avenue des Champs-Elysées
75008 Paris (FR)**

(54) **Simulation de jauge de déformation mécanique**

(57) Un procédé de simulation par ordinateur de déformation mécanique permettant de définir une jauge de déformation dans un modèle d'une structure mécanique pour calculer la déformation au niveau de cette jauge.

Le procédé permet de simuler à la demande le résultat de mesure d'une jauge de déformation dans un modèle de structure mécanique.

Fig.2

**Description**

La présente invention concerne le domaine du développement de structures mécaniques.

Lors de tels développements, des mesures de résistance mécanique sont réalisées. En particulier, ce type de mesures peut être réalisé lors de la phase de certification de la structure mécanique pour assurer que la structure mécanique répond à des exigences de résistance fixées par des normes ou un cahier des charges.

Dans le domaine de l'aéronautique, les mesures de résistance mécanique sont courantes. Avant les essais en vol d'un aéronef, il est vérifié que la structure mécanique de l'aéronef est capable de résister aux contraintes qu'il sera amené à subir en vol.

Dans le développement des structures mécaniques (celles des aéronefs par exemple), il existe un besoin de détecter au plus tôt les comportements mécaniques indésirables pour ne pas retarder le programme de développement ainsi que son coût.

Une campagne de mesure de résistance se déroule en deux temps.

Dans une première phase, la structure mécanique étudiée est modélisée et une simulation d'une déformation mécanique de la structure est réalisée par ordinateur. Cette simulation peut tenir compte de la présence sur la structure mécanique d'éléments de mesure physique de déformation mécanique, typiquement des « jauges de déformation ».

Dans une deuxième phase, un test réel est effectué sur la structure mécanique en imprimant la contrainte mécanique simulée. Les jauges de déformation permettent de recueillir des mesures réelles.

D'une manière générale, les jauges de déformation sont placées à des endroits choisis pour l'étude et l'analyse de zones critiques de la structure mécanique où les déformations mécaniques imposées peuvent affaiblir celle-ci.

Ainsi, une fois la simulation et le test réel effectués, les résultats respectivement issus de ces phases sont comparés pour vérifier que le test réel s'est déroulé ou non conformément aux prévisions de la simulation. Plus précisément, les résultats fournis par les jauges de déformation lors du test réel sont comparés aux résultats de simulation, aux mêmes emplacements dans le modèle.

Pour des mesures de résistance précises et complètes, il convient d'effectuer des mesures de déformations mécaniques à de nombreux emplacements dans la structure mécanique. Il faut alors également lancer des simulations précises dans la modélisation de la structure mécanique pour avoir autant de points de comparaison qu'avec le test réel.

La mise en oeuvre de la simulation peut alors poser des problèmes d'implémentation.

En effet, plus le modèle de la structure mécanique est précis, plus les calculs de simulation sont complexes. Ils nécessitent donc une grande capacité de calcul et une grande capacité de mémoire (pour stocker le modèle, les données de calcul et les résultats de calcul). Les calculs se déroulent alors sur de grandes durées.

Par exemple, pour simuler une structure mécanique d'un aéronef, le temps de simulation est de l'ordre de plusieurs jours.

Lorsqu'une simulation est lancée, il faut donc être sûr du modèle utilisé pour modéliser la structure mécanique. Il faut aussi être sûr de l'emplacement choisi pour les jauges de déformations.

Or, il peut arriver que le positionnement de jauges de déformations soit défini tardivement dans le processus. Pour maintenir l'objectif de précision, il faut alors redéfinir le modèle de la simulation pour inclure le ou les positionnements tardifs. Cependant, cela retarde les mesures de résistance et le programme de développement. Dans certains cas, où une simulation a par exemple déjà été lancée, on peut renoncer à ajouter ou à modifier le positionnement de jauges de déformation.

La modélisation complète d'une jauge de déformation, au sein même du modèle de la structure mécanique offre une bonne précision des résultats de simulation.

Cependant, lorsque les caractéristiques de la jauge de déformation changent, ou que son positionnement dans la structure mécanique change, toute la simulation doit être relancée, éventuellement sur un nouveau modèle modifié.

Une alternative peut consister à effectuer des calculs de déformation mécanique au sein même du modèle simulé.

Cette alternative permet de disposer, une fois les résultats de simulation obtenus, d'une connaissance des déformations mécaniques sur toute la structure.

Cependant, pour que cette connaissance soit complète, et qu'elle ne nécessite pas le lancement de nouvelles simulations, il faut que les calculs de déformation mécanique soient effectués en de nombreux points. La puissance de calcul nécessaire devient alors trop importante pour de grandes structures mécaniques. En outre, le stockage des résultats de simulation et de calcul devient problématique, puisque le volume de données devient lui aussi important.

Selon d'autres alternatives, les déformations mécaniques peuvent être effectuées à partir du déplacement des points du modèle de la structure mécanique simulée.

Cette alternative permet de ne pas relancer la simulation lorsque de nouvelles jauges de déformation sont définies (ou leur position modifiée) pour le test réel.

Cependant, pour pouvoir effectuer ces calculs, il est nécessaire de réaliser un maillage très fin dans le modèle mécanique pour que le calcul soit significatif. En effet, les dimensions d'une jauge de déformation peuvent être de l'ordre de 3 à 6 mm alors que les dimensions d'un élément d'un modèle de simulation sont de l'ordre de plusieurs centimètres. La complexité de calcul est donc accrue.

En outre, les calculs de flexion ne peuvent pas être pris en compte.

Les inventeurs ont donc constaté un besoin pour améliorer les techniques de simulation par ordinateur de déformation mécanique, en particulier dans le cas de structures mécaniques de grandes dimensions telles que des aéronefs.

La présente invention s'inscrit dans ce cadre.

Un premier aspect l'invention concerne un procédé de simulation par ordinateur de déformation mécanique sur une structure mécanique, dans lequel :

- ladite structure mécanique est définie selon un modèle comportant un maillage de ladite structure avec des noeuds de maillage définissant des éléments de maillage,
- un résultat de simulation de déformation mécanique de ladite structure est obtenu, ledit résultat comportant ledit modèle de ladite structure, déformée par ladite simulation de déformation mécanique,
le procédé comportant les étapes suivantes :
- de définition d'au moins une jauge de déformation de simulation entre une première position de départ et une deuxième position de départ par rapport audit modèle, et
pour chaque position de départ :
- de sélection d'un élément de maillage dudit modèle,
- de projection de ladite chaque position de départ sur ledit élément de maillage sélectionné,
- de détermination, à partir dudit résultat de simulation de déformation mécanique, d'une position de la projection de ladite chaque position de départ, sur ledit élément de maillage déformé,
- d'application, à ladite position de ladite projection, d'une transformation inverse à ladite projection pour obtenir une position d'arrivée, et le procédé comportant en outre les étapes de :
- de calcul d'une première distance entre lesdites première et deuxième positions de départ,
- de calcul d'une deuxième distance entre une première position d'arrivée obtenue pour la première position de départ et une deuxième position d'arrivée obtenue pour la deuxième position de départ, et
- de calcul d'une déformation associée à ladite jauge de déformation de simulation, à partir desdites première et deuxième distances.

Un procédé selon le premier aspect permet la simulation optimale de jauges de déformations dans une structure mécanique. Ces jauges de déformation de simulation sont désignées dans la suite par jauges de déformation.

Les calculs nécessaires à une telle simulation sont allégés. En outre, la quantité de mémoire nécessaire à une telle simulation est réduite.

Un procédé selon le premier aspect permet la mise en oeuvre de simulations en cas de définition tardive des jauges de déformation réelles, sans retarder le programme de développement. Il n'est pas nécessaire d'effectuer modification du modèle et de relancer une nouvelle fois une simulation complète lorsque de nouvelles jauges de déformation réelles sont définies.

Un procédé selon le premier aspect permet la simulation de structures mécaniques complexes et la simulation de jauges de déformation dans de telles structures. Un procédé selon le premier aspect permet par exemple de simuler la structure complète d'un aéronef et d'en extraire et d'explorer des informations de déformation mécanique.

L'utilisation d'un procédé selon le premier aspect s'inscrit dans le processus industriel de développement des structures mécaniques, en particulier les structures mécaniques de grandes dimensions (telles que par exemple les aéronefs). De telles structures mécaniques peuvent demander la mise en oeuvre d'un grand nombre de jauges de déformation réelles, parfois jusqu'à plusieurs dizaines de milliers. Il faut alors simuler autant de jauges de déformation de simulation.

L'utilisation d'un procédé selon le premier aspect permet de gagner en temps de développement en réduisant les temps de simulation nécessaires. Elle offre en particulier une grande flexibilité puisque les jauges de déformation peuvent être définies et redéfinies à la demande sans avoir à relancer des simulations complexes.

Un procédé selon le premier aspect est mis en oeuvre par des moyens informatiques.

Il est appliqué à l'application technique particulière de la simulation des jauges de déformations.

Il peut être utilisé dans le but d'une comparaison avec des résultats de mesure de jauges de déformations réelles mises en oeuvre dans un test réel de la structure mécanique modélisée.

Un procédé selon le premier aspect peut comporter la définition du modèle de la structure mécanique.

Il peut en outre comporter la simulation de la déformation mécanique du modèle.

Selon des exemples de réalisation ledit élément de maillage sélectionné est l'élément de maillage dudit modèle le plus proche de ladite chaque position de départ.

Par exemple, ladite sélection dudit élément de maillage comporte les étapes suivantes :

- de détermination d'un noeud du modèle le plus proche de ladite chaque position de départ,
- de détermination d'un ensemble d'éléments de maillage connectés audit noeud le plus proche, et
- de sélection, parmi ledit ensemble d'éléments de maillage, d'un élément de maillage le plus proche de ladite chaque position de départ.

Par exemple, ladite sélection parmi l'ensemble d'éléments de maillage comporte les étapes suivantes :

- de calcul, pour chaque élément de maillage dudit ensemble, d'une distance moyenne entre ladite chaque position de départ et les noeuds du modèle définissant ledit chaque élément de maillage, et

- de comparaison desdites distances moyennes calculées pour chaque élément de maillage dudit ensemble.

Le procédé peut en outre comporter les étapes suivantes :

- de définition d'un premier système de coordonnées associé audit élément de maillage sélectionné, et
- de définition de ladite position de ladite projection dans ledit système de coordonnées,

dans lequel, ledit premier système de coordonnées est défini par une origine prise en un point caractéristique dudit élément de maillage sélectionné et deux vecteurs de base s'étendant depuis ladite origine vers deux noeuds respectifs définissant ledit élément de maillage sélectionné.

Le procédé peut en outre comporter les étapes suivantes :

- de définition d'un deuxième système de coordonnées associé audit élément de maillage sélectionné déformé, ledit deuxième système de coordonnées étant défini par une origine et deux vecteurs de base correspondant à l'origine et aux vecteurs de base du premier système de coordonnées, et
- de détermination de ladite position de ladite projection dans ledit deuxième système de coordonnées.

Par exemple, les coordonnées de ladite position de ladite projection dans le deuxième système de coordonnées sont proportionnelles aux coordonnées de ladite position de ladite projection dans le premier système de coordonnées.

Ladite origine est par exemple prise en un noeud définissant ledit élément de maillage sélectionné ou un centre dudit élément de maillage sélectionné.

Par exemple, ladite transformation inverse est déterminée à partir de rotations subies au niveau dudit élément de maillage sélectionné.

La détermination de ladite transformation inverse peut comporter les étapes suivantes de :

- de sélection d'une pluralité de noeuds définissant ledit élément de maillage sélectionné,
- de détermination de rotations respectives subies par les noeuds de ladite pluralité lors de la déformation mécanique,
- de calcul d'une rotation au niveau de ladite projection de ladite chaque position; et
- détermination de ladite transformation inverse à partir de ladite rotation calculée.

Par exemple, le procédé comporte en outre les étapes suivantes:

- de détermination d'un axe normal audit élément de maillage sélectionné déformé, au niveau de ladite projection de ladite chaque position ;
- d'application de ladite rotation calculée audit axe normal déterminé ; et
- de calcul de ladite position d'arrivée sur l'axe ainsi obtenu.

Ladite position d'arrivée est par exemple calculée à une distance de ladite projection de ladite chaque position égale à la distance séparant ladite chaque position de ladite projection dans le modèle avant déformation.

Selon des réalisations :

- pour deux noeuds $N_i$, $N_j$ opposés de ladite pluralité, d'angles de rotation déterminés respectifs $\alpha_i$, $\alpha_j$, des angles de rotation relatifs respectifs $\alpha_{Ri}$, $\alpha_{Rj}$ sont calculés de la manière suivante :

$$\alpha_{Ri} = \alpha_i - \frac{\alpha_i + \alpha_j}{2},$$

$$\alpha_{Rj} = \alpha_j - \frac{\alpha_i + \alpha_j}{2},$$

et

- pour calculer ladite rotation au niveau de ladite projection de ladite chaque position, un angle de rotation relatif $\alpha_{RP}$ associé à ladite projection est calculé de la manière suivante :

$$\alpha_{RP} = a \times \alpha_{Rk} + b \times \alpha_{Rl},$$

$\alpha_{Rk}$, $\alpha_{Rl}$ étant les angles de rotation relatifs respectifs de deux noeuds $N_k$, $N_l$ de ladite pluralité vers lesquels pointent des axes X et Y dudit deuxième système de coordonnées, et
(a,b) étant les coordonnées de ladite projection dans ledit deuxième système de coordonnées.

Selon des réalisations, ledit calcul de déformation est effectué à partir d'un taux de variation de la distance entre les extrémités de ladite jauge de contrainte suite à ladite déformation.

Par exemple, ladite structure mécanique est celle d'un aéronef.

Un **deuxième aspect** de l'invention concerne un procédé de test de structure mécanique comportant les étapes suivantes :

- de simulation d'une déformation mécanique selon le premier aspect ;
- d'obtention d'un résultat de mesure d'une jauge de déformation réelle, placée conformément à ladite jauge de déformation de simulation sur ladite structure mécanique, ladite jauge de déformation réelle mesurant une déformation mécanique appliquée sur ladite structure mécanique et correspondant à ladite déformation simulée ; et

- de comparaison dudit résultat de mesure et de ladite déformation calculée.

Un **troisième aspect** de l'invention concerne un dispositif de simulation de déformation mécanique et/ou de test de structure mécanique par ordinateur configuré pour la mise en oeuvre d'un procédé selon le premier aspect.

Par exemple, un tel dispositif comporte une unité de traitement configurée pour la mise en d'un procédé selon le premier aspect et/ou le deuxième aspect.

Un **quatrième aspect** de l'invention concerne un programme d'ordinateur ainsi qu'un produit programme d'ordinateur et un support de stockage pour de tels programmes et produit, permettant la mise en oeuvre d'un procédé selon le premier et/ou le deuxième aspect lorsque le programme est chargé et exécuté par un processeur d'un dispositif de simulation de déformation mécanique et/ ou de test de structure mécanique par ordinateur selon des modes de réalisation.

Les objets selon les deuxième, troisième et quatrième aspects de l'invention offrent au moins les mêmes avantages que ceux offerts par l'objet du premier aspect dans ses divers exemples de réalisation.

D'autres caractéristiques et avantages de l'invention apparaîtront à la lecture de la présente description détaillée qui suit, à titre d'exemple non limitatif, et des figures annexées parmi lesquelles :

- les **figures 1a et 1b** illustrent la déformation d'un modèle d'une structure mécanique;
- la **figure 2** est un organigramme d'un procédé général de mise en oeuvre de modes de réalisation;
- la **figure 3** est un schéma bloc illustrant un système de mise en oeuvre de modes de réalisation;
- la **figure 4** illustre la sélection des éléments de maillage du modèle sur lequel sont projetées les extrémités des jauges de déformation;
- les **figures 5a et 5b** illustrent la projection de l'extrémité d'une jauge de déformation sur un élément de maillage sélectionné ;
- la **figure 6** illustre un élément tel que déformé lors de la simulation d'une déformation mécanique ;
- la **figure 7** illustre la flexion d'un élément de maillage et le gradient de rotation qui peut en résulter ;
- la **figure 8** illustre la détermination d'une rotation interpolée ;
- la **figure 9** illustre la détermination d'une transformation inverse pour obtenir une position d'arrivée dans la modèle déformé ; et
- la **figure 10** illustre un dispositif de simulation par ordinateur selon des modes de réalisation.

Selon des modes de réalisation de l'invention, des jauges de déformation sont définies dans un modèle de simulation d'une structure mécanique. Par exemple, il s'agit d'un modèle aux éléments finis.

Chaque jauge de déformation est définie par ses extrémités par deux points de départ A et B dans le modèle initial, c'est-à-dire le modèle avant déformation. L'invention ne se limite pas à des jauges de déformation à une dimension. Cependant, dans un souci de concision, l'exposé ci-après décrit de telles jauges de déformation. L'utilisation d'une jauge à plusieurs dimensions (par exemple une « rosette ») peut se ramener au cas de plusieurs jauges à une dimension.

Ensuite, en fonction du déplacement de ces points de départ, induit par la déformation suite à la simulation d'un ou plusieurs efforts internes (e.g. température, pression ou autre) et/ou externes (aérodynamique, poussée moteurs ou autre) sur la structure, la déformation au niveau de la jauge est déterminée.

Les extrémités de la jauge se trouvent après déformation à des points d'arrivée A' et B' (respectivement).

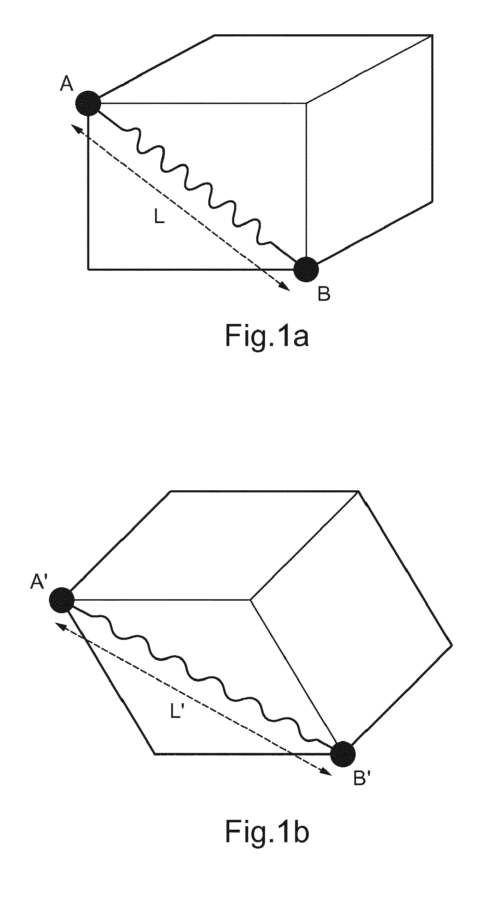

Les **figures 1a et 1b** illustrent la déformation d'un modèle très simple d'une structure mécanique.

Ce modèle est un cube. Il comporte une pluralité de noeuds, qui sont dans cet exemple les coins du cube. Ces noeuds définissent des éléments de maillage, qui sont dans cet exemple les faces du cube.

On suppose que dans l'état initial (figure 1a, avant déformation), une jauge de déformation est définie entre deux coins (ou noeuds) du cube A et B. Dans l'état initial, la distance séparant ces deux points de départ est L.

Dans l'état final, (figure 1b, après déformation), les extrémités de la jauge de déformation se sont déplacées en des points d'arrivée A' et B'. La distance séparant ces points est L'. La structure mécanique modélisée n'a plus la forme d'un cube. Sous l'effet de la déformation, le cube s'est « aplati ».

La déformation au niveau de la jauge peut être déterminée par le taux de variation de la distance entre les extrémités de la jauge de déformation (L-L')/L.

Les figures 1a et 1b présentent le cas simple où les extrémités de la jauge de déformation coïncident avec des noeuds du modèle. Cependant, les jauges de déformations doivent pouvoir être placées librement dans la structure mécanique, comme elles le seront lors du test réel.

Dans la suite, il est décrit une détermination du déplacement des extrémités de la jauge de déformation par interpolation du déplacement de noeuds du modèle de la structure mécanique simulée se trouvant autour de ces extrémités.

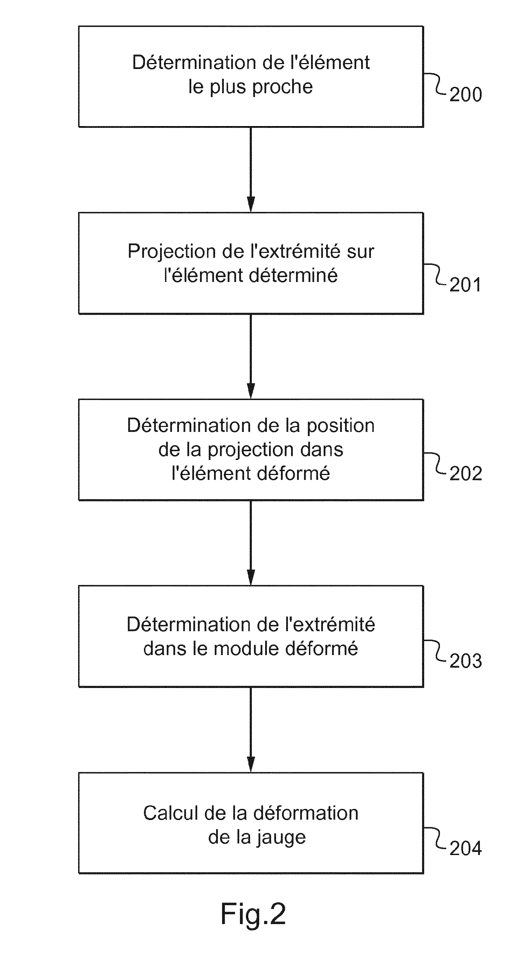

Le procédé général de mise en oeuvre de modes de réalisation est résumé dans l'organigramme de la **figure 2.**

Dans un premier temps, lors d'une étape 200, pour chaque extrémité de la jauge de déformation, l'élément de maillage du modèle de simulation le plus proche est déterminé. Cette étape peut comporter la détermination de tous les éléments de maillage dans le voisinage de l'extrémité. Ces éléments de maillage voisin sont par exemple ceux dont un noeud fait partie des plus proches de l'extrémité.

Ensuite, lors d'une étape 201, l'extrémité est projetée sur l'élément de maillage ainsi déterminé. Il s'agit par exemple d'une projection orthogonale.

Les étapes ci-dessus sont réalisées dans le modèle initial, c'est-à-dire le modèle de la structure mécanique, avant que la déformation mécanique n'ait été simulée.

Pour l'étape suivante 202, les résultats de simulation sont obtenus. On détermine alors la position de la projection de l'extrémité dans l'élément de maillage déformé par la déformation. Comme il est décrit dans la suite, cette détermination peut se faire par expression de cette position dans un repère associé à l'élément de maillage déterminé et qui se déforme avec l'élément de maillage.

Ensuite, lors de l'étape 203, la position de l'extrémité de la jauge dans le modèle déformé est déterminée à partir de la position de la projection de celle-ci. Il peut ne pas s'agir d'effectuer simplement une projection orthogonale inverse. Pour tenir compte des phénomènes de flexion, comme il est décrit dans la suite, une transformation de la projection de l'extrémité sur l'élément de maillage est déterminée à partir des rotations des noeuds définissant l'élément de maillage.

Une fois que chacune des positions des extrémités de la jauge de déformation ont été déterminées dans le modèle déformé, le taux de variation de sa longueur est déterminé lors de l'étape 204 pour en déduire la déformation appliquée à son niveau.

Lorsqu'un test réel sur la structure mécanique simulée est mis en oeuvre, avec une jauge de déformation réelle positionnée au même endroit que celle définie dans le modèle, une comparaison des déformations mesurées est calculée pourra être effectuée.

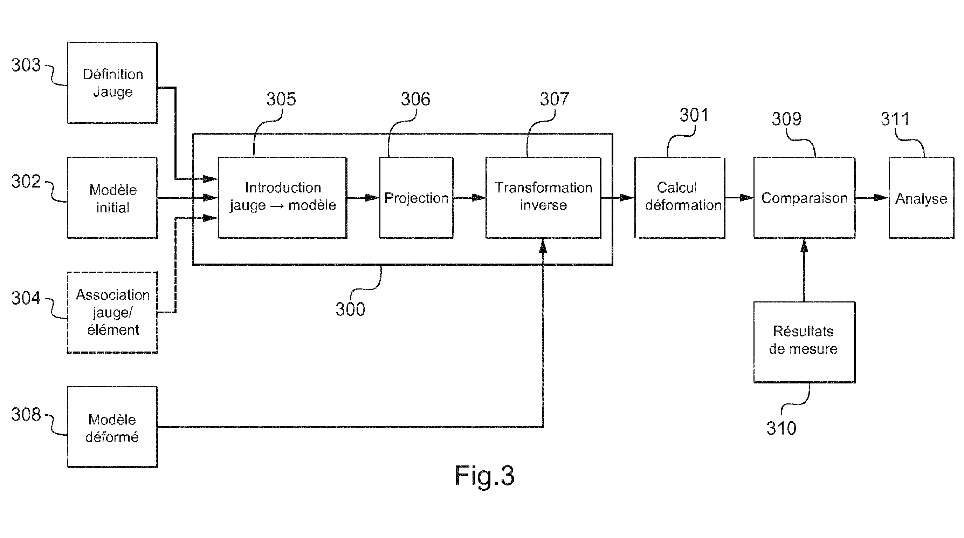

La **figure 3** est un schéma bloc illustrant un système de mise en oeuvre de processus de simulation tel que décrit ci-avant.

Le système comporte par exemple, un module de calculs géométriques 300 et un module de calcul de déformation mécanique 301 qui sont détaillés ci-après.

Le module 300 reçoit en entrée un certain nombre de données issues de modules d'entrée.

Par exemple, le module 302 est un module de définition du modèle initial de la structure mécanique à simuler. Par exemple, le module 302 défini un modèle aux éléments finis qu'il fournit en entrée au module 300.

Le module 303 permet par exemple la définition d'une ou plusieurs jauges de déformations. Par exemple, un utilisateur place les extrémités des jauges de déformations à des endroits à surveiller lors de la phase de test réel pour connaître précisément les déformations mécaniques subis par la structure à ces endroits. La définition des jauges mécaniques peut se faire par navigation dans le modèle initial (défini par le module 302) ou par définition directe (avec des coordonnées).

Pour aider au placement des jauges de déformation, un module 304 peut permettre d'associer une jauge de déformation à un élément de maillage du modèle initial. Par exemple, les éléments de maillage du modèle initial sont désignés par des identifiants et l'utilisateur peut associer une jauge de déformation à un identifiant ce qui peut avoir pour effet de placer automatiquement la jauge de déformation sur l'élément désigné. Cela peut être utile, par exemple pour mettre sous surveillance un groupe d'éléments de maillage représentant une partie spécifique de la structure mécanique (par exemple une aile d'avion). Les éléments du groupe peuvent être associés à un identifiant générique et l'utilisateur, en associant un nombre de jauge de déformations à ce groupe, peut enclencher une répartition des jauges de déformation sur les éléments du groupe. Cela permet ainsi une définition des jauges de déformation plus rapide et plus aisée pour l'utilisateur.

Plus particulièrement, les données issues des modules d'entrée peuvent être fournies, au sein du module 300 à un module 305 d'introduction des jauges de déformation dans le modèle. Le module 305 permet de placer les extrémités des jauges de déformation dans le modèle aux endroits définis par les modules 303 et/ou 304.

Une fois les jauges introduites dans le modèle initial, le modèle ainsi enrichi est traité par un module 306 de projection. Pour chaque extrémité de jauge, le module 306 effectue la sélection d'un élément de maillage du modèle et la projection de l'extrémité sur l'élément sélectionné.

Un module de transformation inverse 307, permet, à partir du modèle déformé, c'est-à-dire issu de la simulation et des résultats du module 306 de placer les projections des extrémités des jauges de déformation dans le modèle déformé.

Le modèle déformé est issu d'un module d'entrée de fourniture de modèle déformé 308. Il peut par exemple s'agir d'un module de simulation ayant reçu en entrée le modèle initial et une définition de la déformation mécanique à simuler.

Une fois que le module 307 a déterminé la position des extrémités des jauges de déformation dans le modèle déformé, le module de calcul de déformation 301 détermine, à partir de la comparaison de la distance entre ces extrémités dans le modèle initial et dans le modèle déformé, la déformation mécanique appliquée au niveau de cette jauge de déformation, d'après la simulation.

Une fois que le test réel est effectué, avec une ou plusieurs jauges de déformation réelles placées aux mêmes endroits que celles simulées, il est possible comparer les données issues des calculs du module 301 à ceux des jauges de déformations réelles. Cette comparaison peut être effectuée par un module de comparaison recevant entrée les calculs de déformation du module 301 et les résultats de mesure des jauges de déformations réelles fournies par un module de stockage 310 des résultats de mesure.

Les résultats de comparaison peuvent ensuite être fournis à un module d'analyse 311 pour corriger et/ou améliorer la structure mécanique ou encore confirmer celle qui a été simulée et testée.

Le processus de détermination des positions d'arrivée des extrémités des jauges de déformations dans le modèle déformé est décrit plus en détails dans ce qui suit.

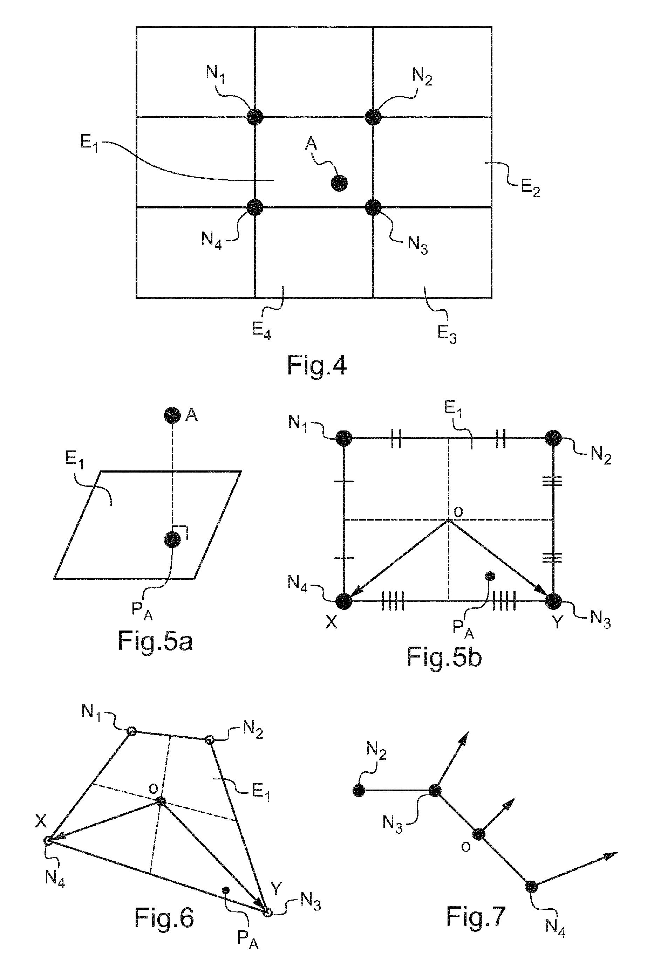

En référence à la **figure 4,** il est décrit la sélection des éléments de maillage du modèle sur lequel sont projetées les extrémités des jauges de déformation.

La figure 4 représente schématiquement une portion de modèle d'une structure mécanique. Dans un souci de clarté, un maillage simple est représenté qui comporte six éléments de maillage ayant la forme d'un parallélogramme (par exemple un carré, un rectangle ou autre). Le maillage peut être en trois dimensions et les éléments de maillage de formes différentes. Le point A représente une position d'une extrémité d'une jauge de déformation.

Dans un premier temps, le noeud le plus proche du point A est recherché. Parmi la pluralité de noeuds du modèle $N_1$, $N_2$, $N_3$, $N_4$ les plus proches du point A, celui à la distance

$$\sqrt{\left(x - x_{A)}\right)^2 + \left(y - y_{A)}\right)^2 + \left(z - z_{A)}\right)^2}$$ la plus faible est sélectionné (le triplet (x, y, z) représente les coordonnées des noeuds considérés et le triplet ($x_A$, $y_A$, $z_A$) ceux du point A). Par exemple, les points $N_1$, $N_2$, $N_3$, $N_4$ sont sélectionnés à partir d'une identification par l'utilisateur de l'élément de maillage $E_1$ sur lequel il souhaitait positionner le point A.

Dans l'exemple de la figure 4, le noeud le plus proche du point A est le noeud $N_3$.

Dans un deuxième temps, on recherche tous les éléments de maillage associés au point $N_3$, c'est-à-dire tous les éléments de maillage définis avec le point $N_3$. Dans l'exemple de la figure 4, il s'agit des éléments $E_1$, $E_2$, $E_3$ et $E_4$.

Dans un troisième temps, l'élément de maillage sur lequel la projection du point A est opérée est sélectionné parmi les éléments $E_1$, $E_2$, $E_3$ et $E_4$. Par exemple, pour chacun des éléments de maillage $E_1$, $E_2$, $E_3$ et $E_4$, la distance moyenne entre le point A et les noeuds définissant ces éléments est calculée

$$\left( \sum_{N_i \in \text{Elément}} \frac{D(N_i, A)}{n} \right.$$, avec $D(N_i, A)$ étant la distance entre le point A et un noeud $N_i$ et n étant le nombre de noeuds $N_i$ définissant l'élément). L'élément de maillage sélectionné est alors celui pour lequel la distance moyenne est la plus faible. Dans l'exemple de la figure 4, il s'agit

de l'élément $E_1$.

En référence aux **figures 5a et 5b,** la projection de l'extrémité d'une jauge de déformation sur un élément de maillage sélectionné est décrite.

La figure 5a représente l'élément de maillage sélectionné $E_1$ et le point A. La projection du point A sur l'élément permet d'obtenir le point $P_A$. Par exemple, la projection est une projection orthogonale.

Une fois la projection obtenue, elle est exprimée dans un système de coordonnées associé à l'élément de maillage $E_1$. Ce système de coordonnées est illustré par la figure 5b.

L'origine O du système de coordonnées est choisie comme étant le centre de l'élément de maillage. Le centre est par exemple choisi ici, dans le cas d'un élément en forme de quadrilatère comme l'intersection des lignes reliant le milieu de deux côtés opposés). Les axes (X, Y) du système sont choisis en sorte que les coordonnées du point $P_A$ soient positives. Ici, l'axe X est dirigé vers le noeud $N_4$ et l'axe Y est dirigé vers le noeud $N_3$.

Par ailleurs, les éléments de maillage peuvent être définis avec une épaisseur. La projection peut alors se faire sur la face la plus proche du point A, ou sur une surface fictive entre les deux faces de l'élément.

Une fois la projection du point A obtenue dans le système de coordonnées associé à l'élément de maillage sélectionné, il est déterminé sa position dans l'élément de maillage déformé suite à la simulation de la déformation mécanique.

La **figure 6** illustre l'élément $E_1$ tel que déformé lors de la simulation de la déformation mécanique sur la structure. Le système de coordonnées défini suit les mêmes déformations. Ainsi, l'origine se retrouve au centre de l'élément de maillage et les axes X et Y sont dirigés vers les noeuds $N_4$ et $N_3$ respectivement.

La projection $P_A$ du point A est alors positionnée sur l'élément de maillage déformé. La position de la projection est définie relativement au système de coordonnées déformé. Ainsi, dans un repère absolu n'étant pas modifié par la déformation, la projection n'a pas les mêmes coordonnées dans l'élément initial et dans l'élément déformé. Par contre, la projection garde les mêmes valeurs de coordonnées dans les systèmes de coordonnées associés respectivement à l'élément initial et à l'élément déformé. Par exemple, si la projection a pour coordonnées (1,1) dans le système de coordonnées de l'élément initial, elle a pour coordonnées (1,1) dans le système de coordonnées de l'élément déformé. On note cependant que les deux coordonnées ne sont pas définies par rapport aux mêmes vecteurs de base puisque ceux du système de coordonnées de l'élément initial ont été modifiés par la déformation pour former ceux du système de coordonnées du système de l'élément déformé. Exprimé de manière différente, la projection garde les mêmes coordonnées en proportion par rapport aux vecteurs de base du système initial et par rapport aux vecteurs du

Dans ce qui suit, la détermination de la position de la projection du point A dans la modèle déformé est décrite en détails. Pour déterminer cette position, opérer une projection orthogonale inverse à celle opérée pour obtenir le point $P_A$ dans le modèle initial, peut ne pas suffire. En effet, comme illustré par la **figure 7,** la flexion de l'élément de maillage peut introduire des rotations différentes selon la position dans l'élément de maillage lui-même.

La figure 7 représente une vue de l'élément de maillage $E_1$ déformé. L'élément est fléchi, ce qui introduit un gradient de rotation. Par exemple, la rotation au noeud $N_3$ est différente de celle au point $N_4$. Ainsi, pour déterminer la rotation au point O par exemple, selon que l'on prenne la rotation en un noeud ou un autre, le résultat est différent.

Pour déterminer la transformation inverse à appliquer à la projection de l'extrémité A, une rotation interpolée est déterminée par interpolation de rotations de noeuds définissant l'élément de maillage déterminé.

Par exemple, la rotation interpolée est déterminée à partir des rotations des noeuds vers lesquels sont dirigés les axes du système de coordonnés associé à l'élément de maillage.

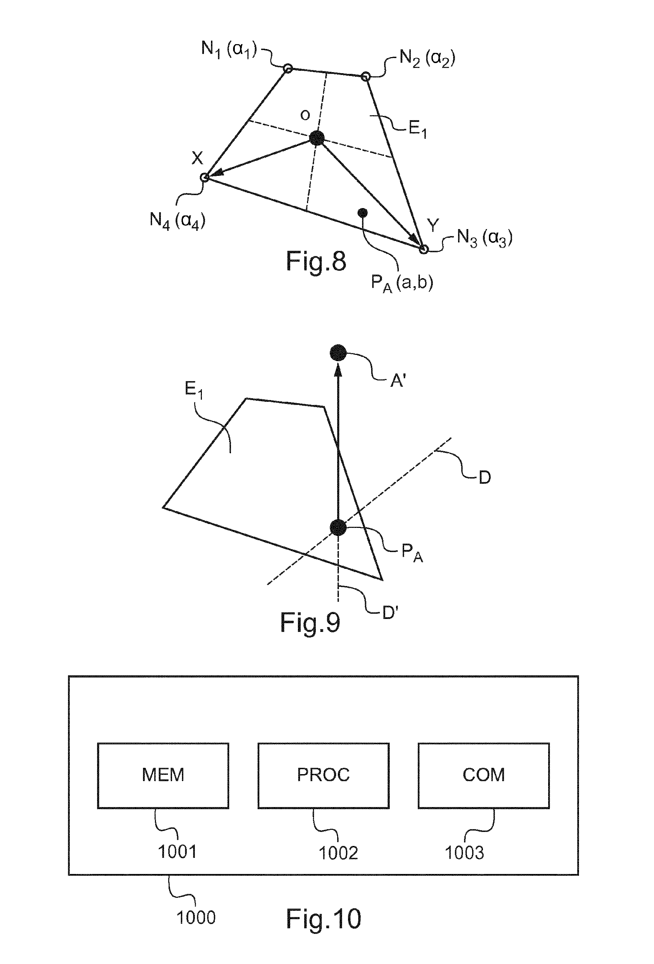

La **figure 8** illustre la détermination de la rotation interpolée.

La figure 8 représente l'élément de maillage déformé sur lequel a été projetée l'extrémité A de la jauge de déformation. A côté de chaque noeud définissant l'élément de maillage, a été représenté l'angle de la rotation qu'a subi le noeud lors de la déformation par rapport à un axe d'un repère absolu associé au modèle de la structure mécanique (repère non représenté). Dans la suite, dans un souci de concision, on ne considérera qu'un seul axe V du repère et les angles de rotation par rapport à cet axe. Cependant, afin de décrire complètement les rotations subies par les noeuds, les angles de rotation par rapport aux autres axes doivent être considérés.

Ainsi, les noeuds $N_1$, $N_2$, $N_3$ et $N_4$ ont respectivement subi une rotation d'angle $\alpha_1, \alpha_2, \alpha_3, \alpha_4$, par rapport à l'axe V du repère.

Afin de se replacer dans le repère local associé à l'élément de maillage, des angles de rotation relatifs sont définis. Par exemple, ils sont définis en sorte que l'angle de rotation que subi l'origine O du repère par rapport à l'axe V est nul.

Par exemple, pour deux noeuds $N_i$, $N_j$ opposés (d'angles de rotation respectifs $\alpha_i$, $\alpha_j$), c'est-à-dire situés de part et d'autre de l'origine, les angles de rotation relatifs respectifs $\alpha_{Ri}$, $\alpha_{Rj}$ sont calculés de la manière suivante :

$$\alpha_{Ri} = \alpha_i - \frac{\alpha_i + \alpha_j}{2}$$

$$\alpha_{Rj} = \alpha_j - \frac{\alpha_i + \alpha_j}{2}$$

Une fois les angles de rotation relatifs déterminés, un angle de rotation relatif $\alpha_{RPA}$ associé à la projection $P_A$ de l'extrémité A de la jauge de déformation est calculé comme une somme des angles de rotation relatifs des noeuds vers lesquels pointent les axes X et Y du système de coordonnées associé à l'élément de maillage $E_1$, cette somme étant pondérée par les coordonnées (a,b) de cette projection dans ce système de coordonnées. Ici les axes X et Y pointent vers les noeuds $N_4$ et $N_3$, l'angle de rotation relatif est alors :

$$\alpha_{RPA} = a \times \alpha_{R4} + b \times \alpha_{R3}$$

Ce calcul d'angle relatif est effectué trois fois pour chaque axe du repère absolu associé au modèle de la structure mécanique. Comme déjà évoqué ci-avant, dans un souci de concision, le calcul n'est présenté qu'une seule fois pour un axe V du repère.

Une fois les trois angles de rotation relatifs déterminés, la rotation ainsi définie par rapport aux axes du repère absolu associé au modèle est utilisée pour déterminer la transformation inverse qui permet de passer de la projection $P_A$ à la position d'arrivée A' du point A dans la modèle déformé.

La **figure 9** illustre la détermination de la transformation inverse pour obtenir la position d'arrivée A' du point A dans la modèle déformé.

Cette figure représente de manière simplifiée l'élément de maillage déformé $E_1$. Dans un premier temps, l'axe D normal à l'élément déformé et passant par la projection $P_A$ de l'extrémité A est déterminé.

On applique ensuite à l'axe D la rotation précédemment déterminée avec les angles relatifs $\alpha_{RPA}$ calculés pour chaque axe du repère absolu. Un axe D' est ainsi obtenu.

Le point A' est alors obtenu en déplaçant le point $P_A$ sur l'axe D'. Par exemple, le point A' est placé à la même distance entre le point A du modèle initial (avant déformation) et le point $P_A$.

Lorsque les positions d'arrivée (A' et B') ont été déterminées pour les deux extrémités (A et B) de la jauge de déformation. Les distances L et L' entre les points de départ A et B et les points d'arrivées A' et B' sont calculées.

Le taux de variation de la distance entre les extrémités de la jauge de déformation (L-L')/L est alors calculé, pour déterminer ensuite la déformation mécanique locale au niveau de la jauge de déformation.

Une fois la déformation mécanique déterminée elle peut être comparée à une déformation mécanique effectivement mesurée par une jauge de déformation réelle sur la structure mécanique. En cas de divergence, il est possible de détecter une anomalie, par exemple dans la conception de la structure mécanique et ainsi de la corriger. En cas de concordance, la structure mécanique peut être validée. Il est alors possible de passer à des tests dans des conditions plus réelles, par exemple un essai en vol d'un aéronef.

En cas de divergence il est aussi possible détecter que le positionnement d'une ou plusieurs jauges de déformation n'était pas adéquat dans la structure mécanique réelle ou dans le modèle.

Il est par ailleurs possible de détecter un mauvais branchement de câble de connexion de la jauge de déformation au système d'acquisition de données.

La comparaison entre les déformations mesurée et déterminée peut permettre de détecter d'autres types de problèmes.

Suite à la détection de d'anomalie, il est possible de revenir soit sur le modèle de la structure mécanique, soit sur la structure elle-même en fonction de la confiance que l'on accorde à l'une ou l'autre.

Un programme d'ordinateur pour la mise en oeuvre d'un procédé selon un mode de réalisation de l'invention peut être réalisé par la personne du métier à la lecture de l'organigramme de la figure 2 et de la présente description détaillée.

La **figure 10** illustre un dispositif de simulation par ordinateur selon des modes de réalisation. Le dispositif 1000 comporte une unité de mémoire 1001 (MEM). Cette unité de mémoire comporte une mémoire vive pour stocker de manière non durable des données de calcul utilisées lors de la mise en oeuvre d'un procédé selon un mode de réalisation. L'unité de mémoire comporte par ailleurs une mémoire non volatile (par exemple du type EEPROM) pour stocker par exemple un programme d'ordinateur selon un mode de réalisation pour son exécution par un processeur (non représenté) d'une unité de traitement 1002 (PROC) de l'équipement. La mémoire peut également stocker d'autres données évoquées ci-avant, par exemple un modèle de structure mécanique, des désignations d'éléments de maillage, la définition de jauges de déformation ou autre.

Le dispositif comporte par ailleurs une unité de communication 1003 (COM) pour mettre en oeuvre des communications, par exemple pour recevoir des données de modélisation de structure mécanique, des résultats de simulation de déformation mécanique sur la structure, des définitions de jauges de déformation. Les communications peuvent aussi être mises en oeuvre pour transmettre des résultats de simulation de jauge de déformation comme par exemple des taux d'accroissement de longueur de jauge ou autre. En particulier, l'unité de communication peut être configurée pour la communication avec une base de données de modélisation de déformation mécanique et de simulation de déformation, avec une interface utilisateur, avec un réseau de communication ou autre.

La présente invention a été décrite et illustrée dans la présente description détaillée en référence aux figures jointes. Toutefois la présente invention ne se limite pas aux formes de réalisation présentées. D'autres variantes, modes de réalisation et combinaisons de caractéristiques peuvent être déduits et mis en oeuvre par la personne du métier à la lecture de la présente description et des figures annexées.

Pour satisfaire des besoins spécifiques, une personne compétente dans le domaine de l'invention pourra appliquer des modifications ou adaptations.

Dans les revendications, le terme "comporter" n'exclut pas d'autres éléments ou d'autres étapes. L'article indéfini « un » n'exclut pas le pluriel. Un seul processeur ou plusieurs autres unités peuvent être utilisées pour mettre en oeuvre l'invention. Les différentes caractéristiques présentées et/ou revendiquées peuvent être avantageusement combinées. Leur présence dans la description ou dans des revendications dépendantes différentes, n'exclut pas en effet la possibilité de les combiner. Les signes de référence ne sauraient être compris comme limitant la portée de l'invention.

## Revendications

1. Procédé de simulation par ordinateur de déformation mécanique sur une structure mécanique, dans lequel :

> - ladite structure mécanique est définie selon un modèle comportant un maillage de ladite structure avec des noeuds de maillage définissant des éléments de maillage,
> - un résultat de simulation de déformation mécanique de ladite structure est obtenu, ledit résultat comportant ledit modèle de ladite structure, déformée par ladite simulation de déformation mécanique,
> le procédé comportant les étapes suivantes :
> - de définition d'au moins une jauge de déformation de simulation entre une première position de départ et une deuxième position de départ par rapport audit modèle, et
> pour chaque position de départ :
> - de sélection d'un élément de maillage dudit modèle,
> - de projection de ladite chaque position de départ sur ledit élément de maillage sélectionné,
> - de détermination, à partir dudit résultat de simulation de déformation mécanique, d'une position de la projection de ladite chaque position de départ, sur ledit élément de maillage déformé,
> - d'application, à ladite position de ladite projection, d'une transformation inverse à ladite projection pour obtenir une position d'arrivée, et le procédé comportant en outre les étapes de :
> - de calcul d'une première distance entre lesdites première et deuxième positions de départ,
- de calcul d'une deuxième distance entre une première position d'arrivée obtenue pour la première position de départ et une deuxième position d'arrivée obtenue pour la deuxième position de départ, et
- de calcul d'une déformation associée à ladite jauge de déformation de simulation, à partir desdites première et deuxième distances.

2. Procédé selon la revendication 1, dans lequel ledit élément de maillage sélectionné est l'élément de maillage dudit modèle le plus proche de ladite chaque position de départ.

3. Procédé selon l'une des revendications précédentes, dans lequel ladite sélection dudit élément de maillage comporte les étapes suivantes :

- de détermination d'un noeud du modèle le plus proche de ladite chaque position de départ,
- de détermination d'un ensemble d'éléments de maillage connectés audit noeud le plus proche, et
- de sélection, parmi ledit ensemble d'éléments de maillage, d'un élément de maillage le plus proche de ladite chaque position de départ.

4. Procédé selon l'une des revendications précédentes, comportant en outre les étapes suivantes :

- de définition d'un premier système de coordonnées associé audit élément de maillage sélectionné, et
- de définition de ladite position de ladite projection dans ledit système de coordonnées,
dans lequel, ledit premier système de coordonnées est défini par une origine prise en un point caractéristique dudit élément de maillage sélectionné et deux vecteurs de base s'étendant depuis ladite origine vers deux noeuds respectifs définissant ledit élément de maillage sélectionné.

5. Procédé selon la revendication 4, comportant en outre les étapes suivantes :

- de définition d'un deuxième système de coordonnées associé audit élément de maillage sélectionné déformé, ledit deuxième système de coordonnées étant défini par une origine et deux vecteurs de base correspondant à l'origine et aux vecteurs de base du premier système de coordonnées, et
- de détermination de ladite position de ladite projection dans ledit deuxième système de coordonnées.

6. Procédé selon la revendication 5, dans lequel les coordonnées de ladite position de ladite projection dans le deuxième système de coordonnées sont proportionnelles aux coordonnées de ladite position de ladite projection dans le premier système de coordonnées.

7. Procédé selon l'une des revendications 4 à 6, dans lequel ladite origine est prise en un noeud définissant ledit élément de maillage sélectionné ou un centre dudit élément de maillage sélectionné.

8. Procédé selon l'une des revendications précédentes, dans lequel ladite transformation inverse est déterminée à partir de rotations subies au niveau dudit élément de maillage sélectionné.

9. Procédé selon la revendication 8, dans lequel la détermination de ladite transformation inverse comporte les étapes suivantes de :

- de sélection d'une pluralité de noeuds définissant ledit élément de maillage sélectionné,
- de détermination de rotations respectives subies par les noeuds de ladite pluralité lors de la déformation mécanique,
- de calcul d'une rotation au niveau de ladite projection de ladite chaque position; et
- détermination de ladite transformation inverse à partir de ladite rotation calculée.

10. Procédé selon la revendication 9, comportant en outre les étapes suivantes:

- de détermination d'un axe normal audit élément de maillage sélectionné déformé, au niveau de ladite projection de ladite chaque position ;
- d'application de ladite rotation calculée audit axe normal déterminé ; et
- de calcul de ladite position d'arrivée sur l'axe ainsi obtenu.

11. Procédé selon la revendication 10, dans lequel ladite position d'arrivée est calculée à une distance de ladite projection de ladite chaque position égale à la distance séparant ladite chaque position de ladite projection dans le modèle avant déformation.

12. Procédé selon l'une des revendications 9 à 11 en combinaison avec la revendication 5, dans lequel :

- pour deux noeuds $N_i$, $N_j$ opposés de ladite pluralité, d'angles de rotation déterminés respectifs $\alpha_i$, $\alpha_j$, des angles de rotation relatifs respectifs $\alpha_{Ri}$, $\alpha_{Rj}$ sont calculés de la manière suivante :

$$\alpha_{Ri} = \alpha_i - \frac{\alpha_i + \alpha_j}{2},$$

$$\alpha_{Rj} = \alpha_j - \frac{\alpha_i + \alpha_j}{2},$$

et

- pour calculer ladite rotation au niveau de ladite projection de ladite chaque position, un angle de rotation relatif $\alpha_{RP}$ associé à ladite projection est calculé de la manière suivante :

$$\alpha_{RP} = a \times \alpha_{Rk} + b \times \alpha_{Rl},$$

$\alpha_{Rk}$, $\alpha_{Rl}$ étant les angles de rotation relatifs respectifs de deux noeuds $N_k$, $N_l$ de ladite pluralité vers lesquels pointent des axes X et Y dudit deuxième système de coordonnées, et
(a,b) étant les coordonnées de ladite projection dans ledit deuxième système de coordonnées.

13. Procédé selon l'une des revendications précédentes, dans lequel ladite structure mécanique est celle d'un aéronef.

14. Procédé de test de structure mécanique comportant les étapes suivantes :

   - de simulation d'une déformation mécanique selon l'une des revendications 1 à 14 ;
   - d'obtention d'un résultat de mesure d'une jauge de déformation réelle, placée conformément à ladite jauge de déformation de simulation sur ladite structure mécanique, ladite jauge de déformation réelle mesurant une déformation mécanique appliquée sur ladite structure mécanique et correspondant à ladite déformation simulée ; et
   - de comparaison dudit résultat de mesure et de ladite déformation calculée.

15. Dispositif de simulation de déformation mécanique et/ou de test de structure mécanique par ordinateur comportant une unité de traitement configurée pour la mise en d'un procédé selon l'une des revendications 1 à 14.

Fig.1a

Fig.1b

Détermination de l'élément
le plus proche                    ⌐200

Projection de l'extrémité sur
l'élément déterminé               ⌐201

Détermination de la position
de la projection dans
l'élément déformé                 ⌐202

Détermination de l'extrémité
dans le module déformé            ⌐203

Calcul de la déformation
de la jauge                       ⌐204

Fig.2

Fig.3

Fig.4

Fig.5a

Fig.5b

Fig.6

Fig.7

$N_1 (\alpha_1)$   $N_2 (\alpha_2)$

$E_1$

O

X

$N_4 (\alpha_4)$

Y   $N_3 (\alpha_3)$

Fig.8

$P_A (a,b)$

A'

$E_1$

D

$P_A$

D'

Fig.9

| MEM | PROC | COM |
|------|------|------|
| 1001 | 1002 | 1003 |

1000   Fig.10

Europäisches
Patentamt

European
Patent Office

Office européen
des brevets

# RAPPORT DE RECHERCHE EUROPEENNE

Numéro de la demande

EP 13 30 6224

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | ANTHEUNIS VERSLUIS ET AL: "Residual shrinkage stress distributions in molars after composite restoration", DENTAL MATERIALS, vol. 20, no. 6, 1 juillet 2004 (2004-07-01), pages 554-564, XP055099859, ISSN: 0109-5641, DOI: 10.1016/j.dental.2003.05.007 * le document en entier * * page 557, colonne 2, ligne 7, alinéa 2 - ligne 10; figure 3 * * page 558, colonne 2, alinéa 2 * ----- | 1-15 | INV. G06F17/50 |
| A | MARTINEZ M ET AL: "Paper;Load monitoring of aerospace structures utilizing micro-electro-mechanical systems for static and quasi-static loading conditions;Load monitoring of aerospace structures utilizing micro-electro-mechanical systems for static and quasi-static loading conditions", SMART MATERIALS AND STRUCTURES, IOP PUBLISHING LTD., BRISTOL, GB, vol. 21, no. 11, 14 septembre 2012 (2012-09-14), page 115001, XP020231599, ISSN: 0964-1726, DOI: 10.1088/0964-1726/21/11/115001 * le document en entier * * abrégé * * page 115001, colonne 2, alinéa 4 * * figures 8-10 * ----- -/-- | 1-15 | DOMAINES TECHNIQUES RECHERCHES (IPC) G06F |

Le présent rapport a été établi pour toutes les revendications

| Lieu de la recherche | Date d'achèvement de la recherche | Examinateur |
|---|---|---|
| Munich | 4 février 2014 | Wellisch, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 13 30 6224

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2012/089375 A1 (KORDT MICHAEL [DE] ET AL) 12 avril 2012 (2012-04-12)<br>* le document en entier *<br>* alinéa [0046] *<br>* alinéa [0080] - alinéa [0084] *<br>----- | 1-15 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 4 février 2014 | Wellisch, J |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**    EP 13 30 6224

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-02-2014

| Document brevet cité<br>au rapport de recherche | Date de<br>publication | Membre(s) de la<br>famille de brevet(s) | Date de<br>publication |
|---|---|---|---|
| US 2012089375 A1 | 12-04-2012 | CN 102460319 A<br>DE 102009002392 A1<br>EP 2419795 A1<br>RU 2011143221 A<br>US 2012089375 A1<br>WO 2010118919 A1 | 16-05-2012<br>04-11-2010<br>22-02-2012<br>10-05-2013<br>12-04-2012<br>21-10-2010 |

EPO FORM P0460